# EUROPEAN PATENT APPLICATION

(11) **EP 3 869 924 A1**
(43) Date of publication of application: **25.08.2021**
(21) Application number: 20158769.8
(22) Date of filing: 21.02.2020
(51) Int. Cl.: H05K 1/02, H05K 1/14, H05K 3/34

(54) **DOUBLE-SIDE PCB SIP ASSEMBLY**

(71) Applicant: Harman Becker Automotive Systems GmbH, 76307 Karlsbad (DE)
(72) Inventor: CECCHIN, Jacopo, 70563 Stuttgart (DE); DAVID, Raluca Bianca, 76137 Karlsruhe (DE); ORCIC, Krunoslav, 76137 Karlsruhe (DE)
(74) Representative: Kraus & Weisert Patentanwälte PartGmbB

(57) **Abstract**

A System-In-Package (SiP) comprises a double-sided PCB with an upper PCB surface, on which upper electrical PCB components are assembled, and a bottom PCB surface, on which bottom electrical PCB components are assembled. At least one spacer substrate is arranged together with the bottom electrical PCB components on the bottom PCB surface, wherein an upper spacer surface of the spacer substrate is mechanically and electrically coupled to the bottom PCB surface, and wherein a bottom spacer surface of the spacer substrate comprises a mounting structure for mounting the PCB assembly to a mainboard PCB and extends in a predefined spacing distance along at least part of the upper spacer surface. The spacer substrate is configured such that, when the PCB assembly is mounted onto a mainboard PCB, the spacer substrate spaces the bottom electrical PCB components from the mainboard PCB.

## Description

### Technical Field

Various examples of the invention generally relate to a double-sided PCB assembly System-In-Package (SiP) assembly. Various examples specifically relate to a SiP assembly with a Land-Grid-Array (LGA) structure comprising a double-sided PCB and a spacer substrate configured suitable to space bottom PCB components from a mainboard PCB.

### Background

Conventional one-side assembly SiP/LGA structures are facing the issue of meeting high requirements in regards to the power integrity of modern high-performance systems, specifically with a combination of the SoC and DRAM

In modern automotive system is possible to distinguish between high performance, frequently updated and most expensive part of the system: "core part" (SoC, DRAM, storages & boot mediums and associated PMIC and passives) and more static low performance part of the system (MCU, video In/Out bridges, tuners, audio, Ethernet switches,... other peripherals and connectors). Additionally, development, validation and qualification investment in "core part" is significant.

The above points would suggest that a high integration solution and reuse of the core parts would be applicable in more customer programs and highly desirable in the future automotive systems.

Currently available techniques like one-sided SiP/LGA are not able to offer this kind of high integration solution due to the fact that the allowed PCB space for a SiP/LGA is limited.

The current high performance SOCs (System-on-Chip) are complex devices that contain many different internal ICs. Most of the ICs require dedicated power supply rails. Each power rail creates a dedicated power supply domain which is directly connected to each respective domain of the SOC using PCB power planes and to a Power Management Integrated Circuit (PMIC) where all the power rails are generated accordingly.

The SOC, DRAM and PMIC(s) PCB integration becomes more and more complex when many of the SOC's IC power rails have a huge static and dynamic current demand (i.e. CPU, GPU, NPU ...). In such case, an extremely low PCB power plane impedance (power integrity) is a strict design requirement to ensure a stable and reliable design and must meet SOC and DRAM requirements.

Having one-side assembly, the distance between current and voltage source (PMICs) and voltage and current sink (SoC and DRAM) cannot be reduced, due to the fact that this distance is depending on the part size and part placement. Based on these preconditions is very difficult or even impossible to decrease the low frequency impedance when having many different power rails.

The capacitors could reduce dramatically the high frequency impedance of the power planes if they are placed near the current sink. In current one-side SiP/LGA solutions, it is almost impossible to place the needed capacitors near the sink for all power rails to be able to decrease the high frequency impedance.

Accordingly, a need exists for improved assembly techniques that overcome or mitigate at least some of the mentioned limitations and disadvantages.

### Summary

This need is met by the features of the independent claims Further advantageous examples are described in the dependent claims.

In the following, the solution according to the invention is described with regard to the claimed PCB assemblies as well as with regard to the claimed PCB assembly methods, wherein features, advantages, or alternative embodiments can be assigned to the other claimed objects. Accordingly, the claims for the PCB assembly methods can be improved by features described or claimed in the context of the PCB assemblies, and vice versa.

A PCB assembly is provided, wherein the PCB assembly comprises a double-sided assembled PCB comprising an upper PCB surface, on which upper electrical PCB contacts are routed and on which upper electrical PCB components are mounted, or assembled, and a bottom PCB surface, on which bottom electrical PCB contacts are routed and on which bottom electrical PCB components are mounted.

The PCB assembly further comprises at least one spacer substrate, which is arranged together with the bottom PCB components on the bottom PCB surface, wherein an upper spacer surface of the spacer substrate is mechanically and electrically coupled to the bottom PCB surface, and a bottom spacer surface of the spacer substrate comprises a mounting structure for mounting the PCB assembly to a mainboard PCB and extends in a predefined spacing distance along at least part of the upper spacer surface, such that, when the PCB assembly is mounted onto a mainboard PCB, the spacer substrate spaces the bottom electrical PCB components from the mainboard PCB.

In various embodiments, the PCB assembly may not comprise a mainboard PCB, wherein the spacer substrate may be configured suitable such that, when the PCB assembly is mounted onto a mainboard PCB, the spacer substrate spaces the bottom electrical PCB components from contact to the mainboard PCB.

In other words, the double-sided PCB may be spaced from a mainboard PCB by a spacer substrate, which may be a plate with a predefined thickness, which is assembled onto the double-sided PCB by solder joints, such that the spacer substrate extends in a direction vertical from the bottom PCB surface higher than the bottom electrical PCB components mounted on the bottom PCB surface.

The upper electrical PCB components may comprise at least one System-On-A-Chip (SoC) assembly. The bottom electrical PCB components may comprise at least one power management integrated circuit (PMIC) with one or more decoupling capacitors, wherein each of the at least one PMIC and/or the decoupling capacitors are arranged at least partly directly under the at least one SoC. The mounting structure on the bottom side of the spacer substrate may comprise one or more of of a ball-grid-array (BGA) structure, a land-grid-array (LGA) structure, and a pin-grid-array (PGA) structure.

The PCB assembly may further comprise a mainboard PCB, wherein the mounting structure on the bottom side of the spacer substrate is mechanically and/or electrically coupled to an upper mounting surface of the mainboard PCB, specifically the PCB assembly may be reflow soldered to the mainboard PCB.

The spacer substrate may be a double-sided PCB, comprising upper electrical spacer contacts formed formed on the upper spacer surface, bottom electrical spacer contacts formed on the bottom spacer surface, electrically conductive paths between the bottom and upper electrical spacer contacts, wherein a spacing distance extends in a vertical direction between the upper and the bottom spacer surface. In other words, the thickness of the spacer substrate may provide the spacer distance between the bottom PCB surface and an upper mainboard PCB surface. When the spacer substrate is a double-sided PCB, optionally a multilayer PCB, such a PCB may be cheaper to produce and may have a higher interconnect density than a conventional spacer substrate with filled, metallized vias.

The double-sided PCB may comprise at least one electrically isolating layer, wherein the spacer substrate may be integrally formed in the at least one electrically isolating layers of the the double-sided PCB. The spacer substrate may be reflow soldered to the bottom PCB surface. The spacer substrate may be integrated in the double-sided PCB, wherein the upper spacer surface may be glued to the double-sided PCB. The spacer substrate may integrated in the double-sided PCB, wherein the upper spacer surface may be annealed into the double-sided PCB.

The PCB assembly may comprises two spacer substrates, wherein the two spacer substrates may be arranged along opposite edges of the double-sided PCB. However, it is to be understood, that also more than two spacer substrates can be used. The at least one spacer substrate is extends along all outer edges of the double-sided PCB, specifically along all four edges of a double-sided PCB, wherein the spacer substrate may form a central opening. For example, the spacer substrate may have a ring shape with a central opening, wherein a mounting structure on the bottom surface of the spacer substrate may be arranged only along two edges of the double-sided PCB.

The mainboard PCB may comprise a recess below the mounted PCB assembly, wherein at least one of the bottom electrical PCB components may extend through the spacer distance and at least partly into the mainboard recess.

The mainboard PCB may further comprises an expose pad extending through the mainboard PCB assembly, wherein a PMIC mounted on the bottom surface of the double-sided PCB may thermally coupled to the expose pad using a thermally conductive and electrically isolating material.

The mounting structure on the bottom spacer surface may comprise a BGA structure, or a LGA structure, or a PGA structure.

A PCB assembly is provided, wherein the PCB assembly comprises a double-sided PCB. Therein, the double-sided PCB comprises an upper PCB surface, on which upper electrical PCB contacts are routed and on which upper electrical PCB components are mounted, and a bottom PCB surface, on which bottom electrical PCB contacts are routed and on which bottom electrical PCB components are mounted. The double-sided PCB is mechanically and electrically mounted with its bottom PCB surface onto a mounting surface of a mainboard PCB, wherein the mainboard PCB comprises a recess through the mounting surface below the double-sided PCB, wherein at least one of the bottom electrical PCB components extend at least partly into the recess.

A method for mounting a double-sided PCB onto a mainboard PCB is provided, comprising the following steps. In a first step, upper electrical PCB components are mounted, i.e. assembled or soldered, on a an upper PCB surface of a double-sided PCB. In another step, bottom electrical PCB components and at least one spacer substrate are mounted on a bottom PCB surface of the double-sided PCB, wherein an upper spacer surface of the spacer substrate is mechanically and electrically coupled to the bottom PCB surface, and a bottom spacer surface of the spacer substrate extends in a predefined spacing distance along at least part of the upper spacer surface and comprises a mounting structure for mounting the spacer substrate onto a mainboard PCB.

In another step, the spacer substrate with the double-sided PCB is assembled on a mainboard PCB, wherein the spacer substrate spaces the bottom electrical PCB components from the mainboard PCB.

By the techniques according to the present disclosure high integration and improved power integrity are enabled in a SiP/LGA module, wherein the number of the devices that can be integrated on the SiP/LGA module may be increased.

Shorter and more effective power planes of the PMIC and associated passives placement on the bottom side of the SiP/LGA much closer to the SOC allow reduced power planes length and sizes, further eliminating the needs of wide power planes for complying with the plane ohmic resistivity limits, wherein shorter planes are characterized by lower resistivity.

The power delivery network may be routed as much as possible as vertical pipes from the DC-DC converter output to the SOC power balls. Using optimized bypass capacitor position, the bypass capacitors may be placed directly under the SOC and they may be connected directly to the power plane going to the SOC power balls (sink). Bypass capacitors may be placed as closest as possible to the sink reducing the effective bypass capacitors mounting inductances. The disclosed techniques may enable reducing the overall power planes dynamic impedance and a lower number of bypass capacitor used for achieving the same dynamic power impedance requirements achievable with the conventional upper surface placing only.

With optimized SiP/LGA power efficiency and decreased power losses provided by the disclosed dual-side placement it is possible to achieve better power impedance results. In particular with low ohmic power planes resistivity (plane DCR) the overall module power efficiency may be improved by decreasing power lost in PCB itself. Improvements in the power plane DCR may lead to higher PCB reliability due to the reduction of the power dissipated from the PCB copper. Enhanced devices integration capabilities on the SiP/LGA provide the possibility to assembly the devices also on the bottom side may increase the total devices integration capability on the SiP/LGA. This may allow including all still missing parts of core part like storage and boot devices at SiP/LGA. Cooling of the bottom placed parts may be improved, wherein critical parts placed at bottom side may be still cooled by connecting it to the expose pad located direct at mainboard over thermal gap filler.

Although specific features described in the above summary and the following detailed description are described in connection with specific examples, it is to be understood that the features may not only be used in the respective combinations, but may also be used isolated, and features from different examples may be combined with each other, and correlate to each other, unless specifically stated otherwise.

Therefore, the above summary is merely intended to give a short overview over some features of some embodiments and implementations and is not to be construed as limiting. Other embodiments may comprise other features than the ones explained above.

### Brief description of the Drawings

In the following, concepts in accordance with exemplary embodiments of the invention will be explained in more detail with reference to the following drawings, in which like reference numerals refer to like elements.
Fig. 1 illustrates a conventional SiP/LGA structure with a one-side assembly, as known in the art.
Fig. 2 schematically illustrates a PCB assembly, according to embodiments of the invention.
Fig. 3 schematically illustrates a upper surface of a PCB, according to embodiments of the invention.
Fig. 4 schematically illustrates the bottom side of the PCB of Fig. 3 including a spacer PCB, according to embodiments of the invention.
Fig. 5 schematically illustrates the bottom side of the PCB of Fig. 3 including another spacer PCB, according to embodiments of the invention.
Fig. 6 schematically illustrates a side view of a PCB assembly, according to embodiments of the invention.
Fig. 7 schematically illustrates the PCB assembly of Fig. 2 with a PMIC on the bottom side of the first PCB connected to a cooling assembly, according to embodiments of the invention.
Fig. 8 schematically illustrates lower components on the first PCB extending into a recess of the mainboard PCB, according to embodiments of the invention.
Fig. 9 schematically illustrates a SOC position on an upper side of the PCB, in a bottom view of the first PCB, according to embodiments of the invention.
Fig. 10 illustrates a flow chart with steps for executing the method according to the invention.

### Detailed description

The above and other elements, features, steps, and concepts of the present disclosure will be more apparent from the following detailed description in accordance with exemplary embodiments of the invention, which will be explained with reference to the accompanying drawings.

It is to be understood that the following description of embodiments is not to be taken in a limiting sense. The scope of the invention is not intended to be limited by the embodiments described hereinafter or by the drawings, which are taken to be illustrative only. The features of the various examples may be combined with each other, unless specifically noted otherwise.

The drawings are to be regarded as being schematic representations, and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling.

Conventional one-side assembly SiP/LGA structures are facing the issue of meeting high requirements in regards to the power integrity of modern high-performance systems, specifically with a combination of the SoC and DRAM

In modern automotive systems is possible to distinguish between high performance, frequently updated and most expensive part of the system: "core part" (SoC, DRAM, storages & boot mediums and associated PMIC and passives) and more static low performance part of the system (MCU, video In/Out bridges, tuners, audio, Ethernet switches,... other peripherals and connectors). Additionally, development, validation and qualification investment in "core part" is significant.

The above points would suggest that a high integration solution and reuse of the core parts would be applicable in more customer programs and highly desirable in the future automotive systems.

The current one-sided SiP/LGA are not able to offer this kind of high integration solution due to the fact that the allowed PCB space for a SiP/LGA is limited.

The current high performance SOCs (System on Chip) are complex devices that contain many different internal ICs. Most of the ICs require dedicated power supply rails. Each power rail creates a dedicated power supply domain which is directly connected to each respective domain of the SOC using PCB power planes and to a Power Management Integrated Circuit (PMIC) where all the power rails are generated accordingly.

The SOC, DRAM and PMIC(s) PCB integration becomes more and more complex when many of the SOC's IC power rails have a huge static and dynamic current demand (i.e. CPU, GPU, NPU ...). In such case, an extremely low PCB power plane impedance (power integrity) is a strict design requirement to ensure a stable and reliable design and must meet SOC and DRAM requirements.

Having one-side assembly, the distance between current and voltage source (PMICs) and voltage and current sink (SoC and DRAM) cannot be reduced, due to the fact that this distance is depending on the part size and part placement. Based on these preconditions is very difficult or even impossible to decrease the low frequency impedance when having many different power rails.

The capacitors could reduce dramatically the high frequency impedance of the power planes if they are placed near the current sink. In current one-side SiP/LGA solutions, it is almost impossible to place the needed capacitors near the sink for all power rails to be able to decrease the high frequency impedance.

In the following a double side assembly SiP/LGA structure with high integration and improved power integrity will be explained.

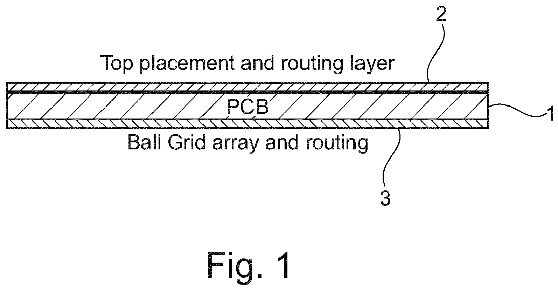

Fig. 1 illustrates a conventional SiP/LGA structure with a one-side assembly, as known in the art.

As can be seen in Fig. 1, a conventional single-sided PCB 1 comprises a top placement and routing layer 2 and a bottom ball grid array and routing structure 3. Here, for example, a SoC and a power source would have to be mounted besides each other on the on top placement and routing layer 2.

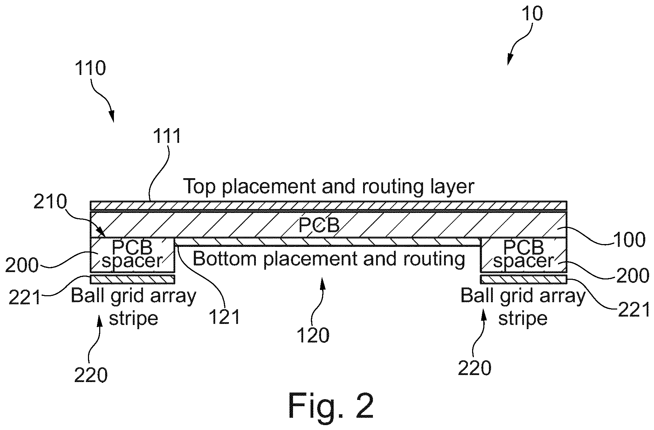

Fig. 2 schematically illustrates a PCB assembly, according to embodiments of the invention.

As can be seen in Fig. 2, a dual-side assembly, i.e. top and bottom assembly, SiP/LGA structure may be realized using a PCB 100 with a top placement and routing layer 111, wherein a PCB spacer 200 is located at the bottom side of the PCB 120.

The double-sided PCB 100 has a placement and routing layer 111 on its upper PCB surface 110 and a bottom placement and routing layer 121 on its bottom PCB surface 120.

As can be seen in Fig. 2, a PCB spacer 200 is arranged on the bottom PCB surface 120, wherein the PCB spacer 200 is connected with its upper surface directly to the bottom surface of the PCB. For example the PCB spacer 200 may be integrated into the PCB 100, by gluing or annealing.

On the bottom surface 220 of the PCB spacer 200, there are two ball grid array stripes 221, which extend along to outer edges of the bottom PCB surface. The ball grid array stripes 221 may be used to electrically and mechanically connect the PCB assembly 10 to another PCB, such as a mainboard PCB (not shown in Fig. 2), wherein board grid array stripes 221 may be soldered to a mounting surface of the mainboard PCB. It can be seen, that the bottom placement and routing layer 121 and the ball grid array stripes, i.e. the mounting structure 221 on the bottom surface of the PCB spacer 200, are spaced from each other in the vertical direction by the thickness of the PCB spacer 200. Within the recess formed by the PCB spacer 200 on the bottom PCB surface 120, electrical components may be mounted on the bottom placement and routing layer 121, such that the height of the bottom components is lower then the i.e. the thickness, of the PCB spacer 200. In such a way, bottom electrical PCB components may be fully contained in the recess in the PCB spacer 200.

In other wrds, with the PCB assembly according to the present disclosure, SiP/LGA pads 221 are located on the bottom side of the spacer 220, wherein the gained space at the bottom side is be used for component placement and routing area 121. The spacer PCB 200 is mainly used for carrying the signals to the SiP/LGA balls and it may , for example be done using simple through-hole vias.

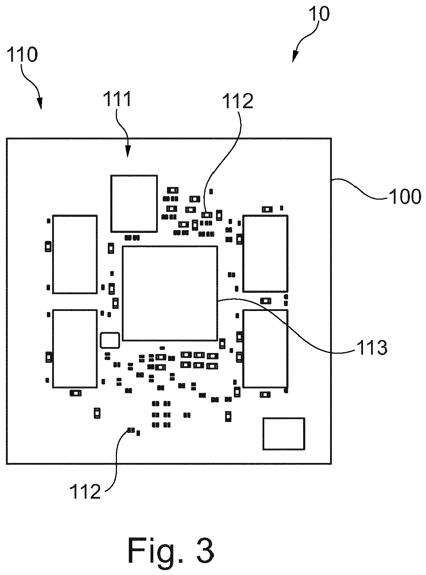

In such a way, the dual-side assembly structure according to the present disclosure maximizes the number of the devices that can be integrated on the SiP/LGA module, as explained in the following examples shown in Figs. 3, 4 and 5.

Fig. 3 schematically illustrates a upper PCB surface , according to embodiments of the invention.

As can be seen in Fig. 3, a PCB assembly 10 is depicted in a top view, wherein the upper PCB surface 110 comprises a routing and placement layer with upper electrical contacts 111, on which upper electrical PCB components 112 and at least one System-on-Chip (SOC) 113 are assembled.

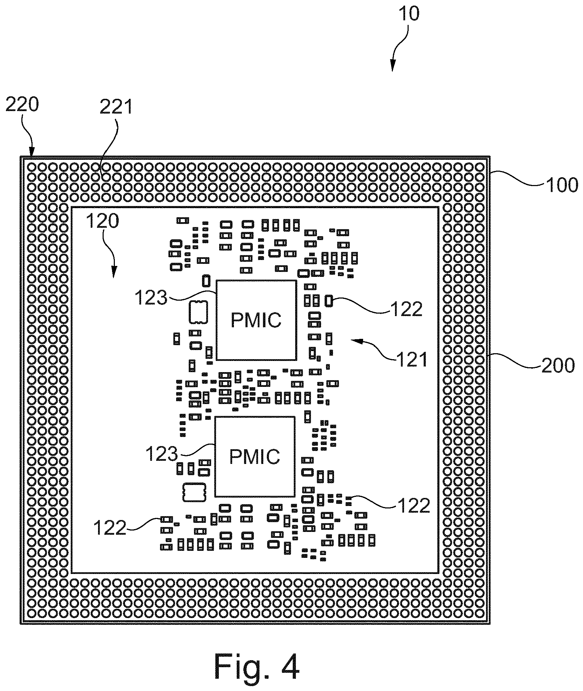

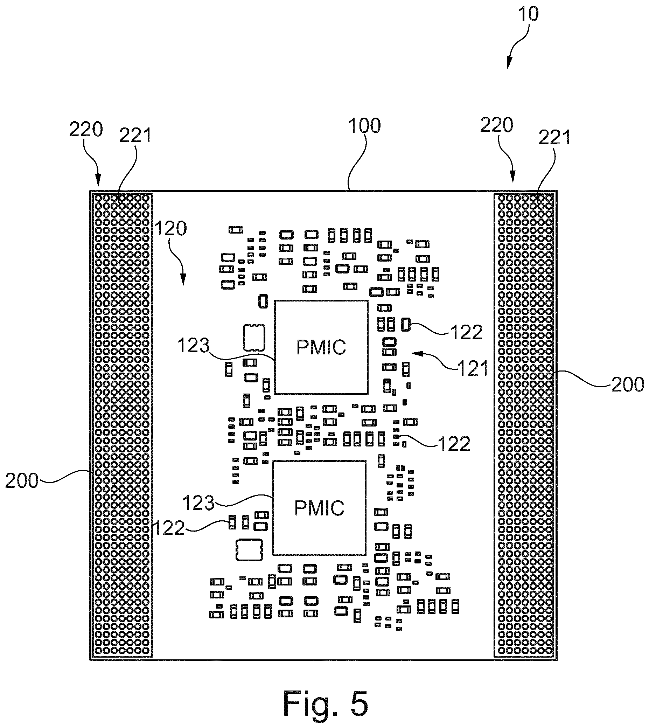

Figs. 4 and 5 schematically illustrate the bottom side of the PCB of Fig. 3 including exemplary spacer PCBs 200, according to embodiments of the invention.

On the bottom side of the PCB 120, the configuration of the PCB spacer 200 can be for example on 4 or 2 sides of the PCB, as explained with reference to Figs. 4 and 5 showing show both examples, wherein both solutions have similar benefits. However it is to be understood, that also the disclosed technices are not limited to the depicted shapes of spacer substrates, wherein any differently shaped PCB spacer with any differently shaped bottom BGA structure may be used.

As can be seen in Fig. 4, all four sides of the spacer PCB have been used for the ball allocation on the spacer. A PCB assembly 10 with a double-sided PCB 100 and a PCB spacer 200 is depicted in a bottom view. On the bottom PCB surface 120, in a central opening of the PCB spacer 200, a routing and placement layer including bottom electrical PCB contacts 121 are located, on which bottom electrical PCB components 122 are assembled. The bottom electrical PCB components 122 include two power management integrated circuits (PMIC) 123. Around the bottom electrical PCB components 122, in a closed ring shape, a spacer PCB 200 is mounted onto the bottom PCB surface 120. On the bottom spacer surface 220, a mounting structure 221 is formed, which also has a closed ring shape. In the example of Fig. 4, BGA mounting structure 221 is located directly along all outer edges of PCB one hundred, wherein the bottom electrical PCB components are located in the center of the PCB 100.

As can be seen in Fig. 5, an assembled double-sided PCB 100 is electrically and mechanically connected on two sides with a spacer PCB 200. In this example, only two sides of the spacer PCB 200 have been used for the ball allocation on the spacer PCB 200. It is to be understood, that 2 separate spacer PCBs 200 may be used, or a single PCB spacer having a central opening may be used, wherein only on two stripes along opposite outer edges of double-sided PCB 100 a mounting structure 221 may be formed.

The structures according to the present disclosure, such as the assembly of a double-sided mounted PCB and a PCB spacer mounted to the PCB, can also be created as a single monolithic PCB instead of by an assembly using two PCBs, i.e. a double-sided and a spacer PCB. In the case of two PCBs, the second PCB (spacer) will be populated and reflowed together with all other parts that are located on the bottom side of the PCB.

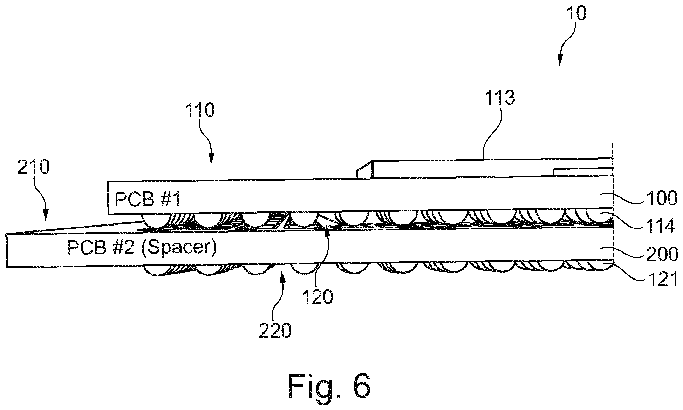

Fig. 6 schematically illustrates a side view of a PCB assembly 10, according to embodiments of the invention.

As can be seen in Fig. 6, the PCB assembly 10 is a dual PCB-structure with a spacer PCB 200, on which a double-sided PCB 100 with a SOC 113 is mounted. On each of the bottom side 120 of the first double-sided PCB 100 and the bottom side 220 of the second spacer PCB a BGA structure (114, 121) is formed for mechanical and electrical connection.

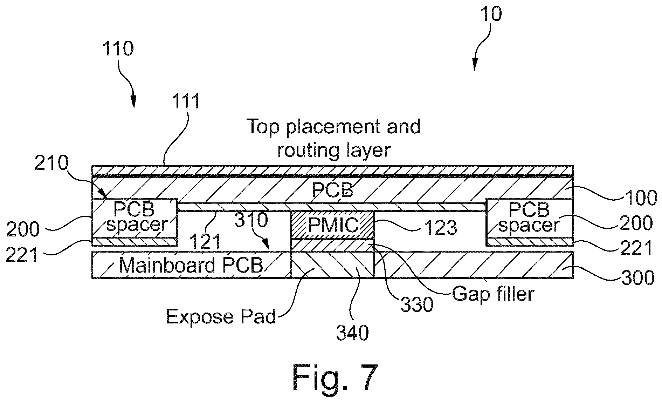

Fig. 7 schematically illustrates the PCB assembly 10 as described in Fig. 2 with a PMIC 123 on the bottom side 120 of the first double-sided PCB 100 , which is connected to a cooling assembly, according to embodiments of the invention.

As depicted in Fig. 7, a cooling solution is provided for critical components, such as an PMIC 123, by using an exposed pad 340 on the mainboard PCB 300 and a thermally conductive gap filler 330.

Critical parts, for example PMICs 123, which control flow and/or direction of electrical power, or other thermally critical components with thermal hotspots, may be placed on the bottom PCB surface 120 and may be cooled by connecting them to an expose pad 340 located direct at the mainboard PCB 300 using a thermal gap filler 330. In various examples, an expose pad 340 may be also directly coupled to the chassis on the bottom side of the mainboard PCB 300 for a better heat dissipation.

The upper spacer surface 210 may be level with the bottom PCB side, or recessed into the bottom PCB side. The upper spacer surface 210 may extend in a vertical direction through the routing metallization layer on the bottom PCB side. Accordingly, the bottom PCB side may form a recess, in which the spacer PCB may be recessed-mounted, or arranged, wherein higher mechanical stability and better electrical isolation may be provided.

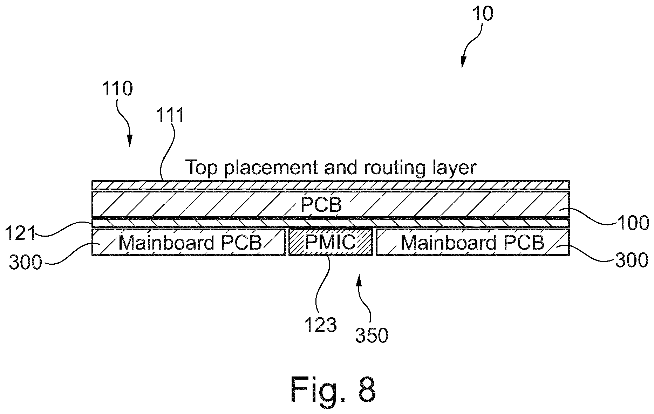

Fig. 8 schematically illustrates lower components on the first PCB extending into a recess of the mainboard PCB, according to embodiments of the invention.

An alternative, or additional, solution to the using of spacers, may be by fitting the bottom components into a cavity 350 located on the mainboard PCB 300, as explained with reference to Picture 8. This technique offers a possibility of a dual assembly SiP/LGA but optionally without the PCB spacer 200.

As can be seen in Fig. 8, a PCB assembly 10 comprises a double-sided PCB 100, which is directly mounted onto a mainboard PCB 300 using a mounting structure 121. The double-sided PCB 100 comprises a top placement and routing layer 111 on its upper PCB surface 110. Therein, bottom PCB components 122, specifically a PMIC 123, which are mounted on the bottom side 120of the first dual-sided PCB, are fitted in a cavity 350 of the mainboard PCB 300.

In the example of Fig. 8, no spacer substrate is depicted, however in various examples, additionally a spacer PCB 200 may be used, wherein at least one component may extend through the spacer PCB and into a cavity in the main PCB.

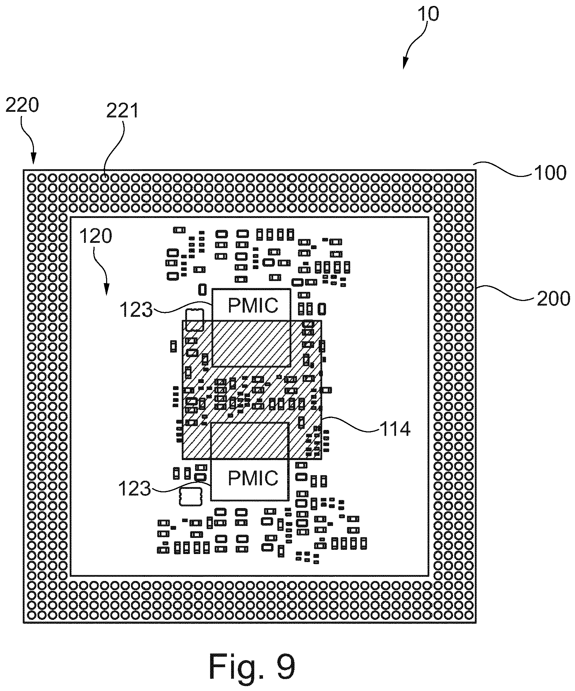

Fig. 9 schematically indicates a SOC 113 position on an upper side 110 of the double-sided PCB 100 of a PCB assembly 10, as seen in a bottom view of the double-sided PCB 100, according to embodiments of the invention. As can be seen in the bottom view in Fig. 9, decoupling capacitors may be placed under the SOC.

The double side assembly SiP/LGA Module according to the present disclosure will solve the high integration issue that the current one-side assembly SiP/LGA modules are facing and also solve the power integrity issues to reach and exceed the expected performance without compromising the performance of the system. Specifically, as explained with reference to Fig. 9, a SOC and decoupling capacitors may be positioned such that the decoupling capacitors are placed under the SOC.

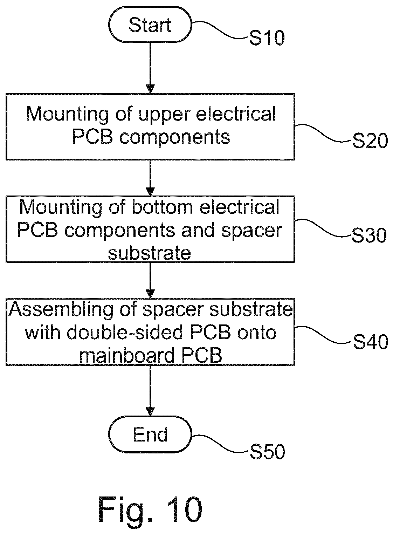

Fig. 10 illustrates a flow chart with steps for assembling a double-sided PCB onto a mainboard PCB, according to the invention.

The method starts with step S10. In step S20, upper electrical PCB components are mounted on an upper side of a double-sided PCB. In step S30, bottom electrical PCB components are mounted together with a spacer substrate onto a bottom surface of the double-sided PCB. In step S40, the spacer substrate is assembled with the double-sided PCB onto a mainboard PCB, such that the spacer PCB is located between the double-sided PCB and the mainboard PCB and spaces the bottom electrical PCB components from contacting the mainboard PCB. The method ends in step S50.

From the above said, the following general conclusions may be drawn:
The spacer substrate may be a PCB comprising a solderable structure on each of the upper and lower spacer surface, in order to be connected to a double-sided assembled PCB, on which on which components may be mounted and/or electrically contacted on both outer sides, wherein also multiple electrically conducting layers within the PCB are possible, i.e. a multilayer PCB.

Electrical connections between the mainboard and the double-sided PCB may lead only through the spacer PCB. All PMICs may be arranged on the bottom side of the dual-sided PCB, specifically centrally within a spacer PCB recess.

A LGA or a PGA structure on the bottom side of the spacer substrate may provide a releasable connection to a mainboard PCB. A BGA structure on the bottom side of the spacer substrate may provide a permanent, soldered connection to a mainboard PCB.

A spacer substrate may be an integral part of the double-sided PCB. The spacer substrate may be formed as a cavity through one or more layers of the double-sided PCB.

The spacer substrate may have a dimension smaller than the double-sided PCB, wherein the spacer substrate may not extend beyond the footprint of the double-sided PCB when mounted to a mainboard PCB. In other words, the spacer substrate may be completely under the double-sided PCB and may not extend to a side of the double-sided PCB. The solder joints between the spacer and the double-sided PCB may provide the complete mechanical and electrical connections between the spacer and the double-sided PCB.

The complete bottom surface of the spacer substrate may be a mounting structure, i.e. BGA structure. The BGA solder joints may provide the complete mechanical and electrical coupling of the double-sided PCB to the mainboard PCB.

The mounting of the upper and bottom electrical components and the spacer substrate onto the double-sided PCB, and the mounting of the PCB assembly, i.e. the spacer substrate with the double-sided PCB, onto the mainboard PCB may be performed using reflow soldering, for example SMT soldering.

The spacer substrate may comprise all electrical connections between the mainboard PCB and the double-sided PCB.

The spacer substrate may be included in the PCB, such that one monolithic PCB comprises upper and bottom SMT mountable surfaces and the spacer substrate for spacing bottom side electrical components from a mainboard.

In various examples, the upper electrical PCB components may comprise ICs and/or passive electrical components.

The spacer substrate may form a rectangular, and/or central, and/or ring-shaped, recess or opening for mounting bottom PCB components.

The electrical components arranged within the spacer and/or besides the spacer may comprise one or more of passive electrical components, active electrical components, DRAM components.

PCB assembly may also be referred to as a substrate assembly, and/or a SiP assembly, and/or a SiP/LGA assembly.

The techniques according to the present disclosure may specifically be used for a combination of one or more of SoC assemblies and DRAM components as upper PCB components.

Summarizing, a PCB assembly and corresponding method for assembling a double-sided PCB on a mainboard PCB is provided, wherein between a double-sided assembled PCB and a mainboard PCB, a spacer substrate is arranged. The spacer substrate may advantageously be a second double-sided PCB with upper and lower electrical contacts and interconnects having a predefined thickness greater than bottom PCB component height, such that the spacer substrate spaces, or separates the double-sided PCB from a mainboard PCB, such that the bottom electrical PCB components are contained in a recess between the double-sided PCB and the mainboard PCB. In a preferred example, one or more SoC are arranged on an upper PCB side directly over one or more PMIC on the bottom PCB side. Thereby, high integration with improved power integrity may be provided in a SiP, and more components may be accommodated closer to each other within a SiP-assembly.

Although the invention has been shown and described with respect to certain preferred embodiments, equivalents and modifications will occur to those skilled in the art upon the reading and understanding of the specification. The present invention includes all such equivalents and modifications and is limited only by the scope of the appended claims.

## Claims

1. A PCB assembly (10) comprising:
- a double-sided PCB (100) comprising an upper PCB surface (110), on which upper electrical PCB components (112) are assembled, and a bottom PCB surface (120), on which bottom electrical PCB components (122) are assembled;
- at least one spacer substrate (200), which is arranged together with the bottom electrical PCB components (122) on the bottom PCB surface (120), wherein an upper spacer surface (210) of the spacer substrate (200) is mechanically and electrically coupled to the bottom PCB surface (120), and wherein a bottom spacer surface (220) of the spacer substrate (200) comprises a mounting structure (221) for mounting the PCB assembly (10) to a mainboard PCB (300) and extends in a predefined spacing distance along at least part of the upper spacer surface (210),
wherein the spacer substrate is configured such that, when the PCB assembly (10) is mounted onto a mainboard PCB (300), the spacer substrate (200) spaces the bottom electrical PCB components (122) from the mainboard PCB (300).

2. The PCB assembly (10) according to claim 1, wherein:
- the upper electrical PCB components (112) comprise at least one System-On-Chip (SoC, 113) assembly; and
- the bottom electrical PCB components (122) comprise at least one power management integrated circuit (PMIC, 123);
wherein each of the at least one PMIC (123) is arranged at least partly directly under the at least one SoC (113) on the double-sided PCB (100).

3. The PCB assembly (10) according to one of the preceding claims, wherein:
- the PCB assembly (10) further comprises a mainboard PCB (300), wherein the mounting structure (221) on the bottom side of the spacer substrate (200) is mechanically and electrically coupled to a mounting surface (310) of the mainboard PCB (300).

4. The PCB assembly (10) according to one of the preceding claims, wherein the spacer substrate (200) is a double-sided PCB comprising:
- upper electrical spacer contacts formed on the upper spacer surface (210);
- bottom electrical spacer contacts formed on the bottom spacer surface (220);
- electrically conductive paths between the bottom and upper electrical spacer contacts (210, 220);
- a spacing distance extending in a vertical direction between the upper and bottom spacer surfaces (210, 220).

5. The PCB assembly (10) according to one of the preceding claims, wherein the spacer substrate (200) is integrally formed by at least one electrically isolating layer of the the double-sided PCB (100).

6. The PCB assembly (10) according to one of claims 1-4, wherein the spacer substrate (200) is reflow soldered to the bottom PCB surface (120).

7. The PCB assembly (10) according to one of claims 1-4, wherein the spacer substrate (200) is integrated in the double-sided PCB (100), wherein the upper spacer surface (210) is glued to the double-sided PCB (100).

8. The PCB assembly (10) according to one of claims 1-4, wherein the spacer substrate (200) is integrated in the double-sided PCB (100), wherein the upper spacer surface (210) is annealed into the double-sided PCB (100).

9. The PCB assembly (10) according to one of the preceding claims, wherein the PCB assembly (10) comprises two separate spacer substrates (200), wherein the two separate spacer substrates (200) are arranged along opposite edges of the double-sided PCB (100).

10. The PCB assembly (10) according to one of claims 1-8, wherein the at least one spacer substrate (200) and its mounting structure (221) extend in a ring-shape along the outer edges of the double-sided PCB (100) and form a central opening, in which the bottom PCB components (122, 123) are located.

11. The PCB assembly (10) according to one of claims 3-10, wherein the mainboard PCB (300) comprises a recess (350) below the mounted PCB assembly (10), wherein at least one of the bottom electrical PCB components (122) extend through the spacer distance and at least partly into the mainboard recess (350).

12. The PCB assembly (10) according to one of claims 3-11, wherein the mainboard PCB further comprises an expose pad (340) extending through the mainboard PCB (300), wherein a PMIC (123) mounted on the bottom surface of the double-sided PCB (100) is thermally coupled to the expose pad (340) using a thermally conductive and electrically isolating material (330).

13. The PCB assembly (10) according to one the preceding claims, wherein the mounting structure (221) on the bottom spacer surface (220) comprises a ball grid array (BGA) structure, or a land grid array (LGA) structure, or a pin grid array (PGA) structure.

14. A PCB assembly (10), wherein:
- a double-sided PCB (100) comprises an upper PCB surface (110), on which upper electrical PCB contacts (111) are routed and on which upper electrical PCB components (112) are mounted, and a bottom PCB surface (120), on which bottom electrical PCB contacts (121) are routed and on which bottom electrical PCB components (122) are mounted;
- the double-sided PCB (100) is mechanically and electrically connected with its bottom PCB surface (120) onto a mounting surface (310) of a mainboard PCB (300);
- wherein the mainboard PCB (300) comprises a recess (350) through the mounting surface (310) below the double-sided PCB (100), wherein at least one of the bottom electrical PCB components (122) extend at least partly into the recess (350).

15. Method for mounting a PCB assembly (10), comprising the following steps:
- assembling upper electrical PCB components (112) on a an upper PCB surface (110) of a double-sided PCB (100);
- assembling bottom electrical PCB components (122) and at least one spacer substrate (200) on a bottom PCB surface (120) of the double-sided PCB (100), wherein an upper spacer surface (210) of the spacer substrate (200) is mechanically and electrically coupled to the bottom PCB surface (120), and a bottom spacer surface (220) of the spacer substrate (200) extends in a predefined spacing distance along at least part of the upper spacer surface (210) and comprises a mounting structure (221) for mounting the spacer substrate (200) onto a mainboard PCB (300);
- assembling the spacer substrate (200) with the double-sided PCB (100) on a mainboard PCB (300), wherein the spacer substrate (200) spaces the bottom electrical PCB components (122) from the mainboard PCB (300).
